# FASCICULE DE BREVET EUROPEEN

(11) **EP 3 503 322 B1**
(45) Date de publication et mention de la délivrance du brevet: **22.04.2026**
(21) Numéro de dépôt: 18209541.4
(22) Date de dépôt: 30.11.2018
(51) Int. Cl.: H02G 3/08, H02G 3/12, H02G 3/18

(54) **SUPPORT D'APPAREILLAGE ÉLECTRIQUE RECEVANT UN ÉLÉMENT DE MONTAGE**
HALTERUNG FÜR ELEKTRISCHE GERÄTE, DIE EIN MONTAGELEMENT AUFNIMMT
ELECTRICAL SWITCHGEAR MOUNTING RECEIVING A MOUNTING MEMBER

(30) Priorité: 22.12.2017 FR 1763035
(43) Date de publication de la demande: 26.06.2019
(73) Titulaire: Legrand France, 87000 Limoges (FR); Legrand SNC, 87000 Limoges (FR)
(72) Inventeur: BAUDOU, Alain, 87000 Limoges (FR)
(74) Mandataire: Jacobacci & Partners France

(56) Documents cités:
- EP-A1- 1 675 235
- EP-A1- 2 790 282
- EP-A1- 2 966 741
- DE-U1- 29 800 074
- GB-A- 2 276 983
- US-A1- 2006 207 781

## Description

### DOMAINE TECHNIQUE AUQUEL SE RAPPORTE L'INVENTION

La présente invention concerne de manière générale le domaine des appareillages électriques, et en particulier des supports d'appareillage électrique.

Elle concerne plus précisément un support d'appareillage électrique selon le préambule de la revendication 1.

L'invention concerne également un appareillage électrique comportant un tel support d'appareillage électrique et un mécanisme d'appareillage électrique fixé dans l'ouverture d'accueil de ce support d'appareillage électrique.

### ARRIERE-PLAN TECHNOLOGIQUE

Un support d'appareillage électrique du type précité est déjà connu du document FR1456539, publié sous le numéro FR3023426, appartenant aux Demanderesses. Le corps d'un tel support d'appareillage électrique reçoit dans son logement une plaquette comportant une ouverture traversante pour permettre le passage d'une vis de fixation à une boîte électrique murale.

L'assemblage de la plaquette sur le corps d'un tel support d'appareillage électrique est minutieux dans la mesure où il convient d'incliner la plaquette par rapport au corps pour l'insérer dans le logement.

Le montage et la fixation de ce support d'appareillage électrique sur la boîte électrique sont également délicats, l'installateur devant veiller à ce que la plaquette reste assemblée dans le logement malgré le redressement, en général vertical, du support d'appareillage électrique et l'insertion de la vis de fixation à travers la plaquette jusque dans l'emplacement de la boîte électrique prévu à cet effet. En outre, lors de la fixation, l'installateur peut pivoter la plaquette contre le fond du logement afin de rattraper le positionnement angulaire du support sur la boîte électrique, mais, ce faisant, il doit encore veiller à ce que la plaquette ne s'échappe pas du logement.

Par ailleurs, la plaquette de ce support d'appareillage électrique est réalisée en matériau métallique pour résister aux efforts exercés par la vis de fixation sur ladite plaquette. Or, le fonctionnement d'un mécanisme d'appareillage électrique présentant une fonction d'émission ou de réception d'ondes radio, fixé dans ce support d'appareillage électrique, est susceptible d'être perturbé par la présence du métal. Par conséquent, les conditions d'utilisations d'un tel support d'appareillage électrique sont limitées.

On connait également du document DE29800074 un support de câbles pour boîte de jonction, dans lequel un corps de support reçoit des plaquettes dans des coulisseaux prévus en saillie sur le corps de support. Ces plaquettes sont imperdables selon la direction de fixation du support sur la boîte de jonction, mais elles rendent le support très encombrant.

De plus, on connait du document EP2966741 A1 un support d'appareillage électrique.

### OBJET DE L'INVENTION

Afin de remédier aux inconvénients précités de l'état de la technique, la présente invention propose un support d'appareillage électrique dont le montage et la fixation à un élément de réception sont facilités, et dont l'élément de montage peut être assemblé et désassemblé aisément du corps de manière à permettre son interchangeabilité avec un autre élément de montage, en fonction des conditions d'utilisation dudit support d'appareillage électrique.

Plus particulièrement, on propose selon l'invention un support d'appareillage électrique selon la revendication 1.

Ainsi, les moyens de coulissement autorisent un assemblage et un désassemblage aisé de l'élément de montage dans le logement, quel que soit cet élément de montage. Il est alors possible d'échanger facilement un premier élément de montage avec un deuxième élément de montage, en fonction des conditions d'utilisation du support d'appareillage électrique. Notamment, il est possible de changer facilement le type d'élément de montage utilisé pour la fixation du support d'appareillage électrique à l'élément de réception, ou le matériau de l'élément de montage. Par exemple, il est possible d'échanger un élément de montage formé d'une plaquette en matériau métallique, munie d'une ouverture traversante pour le passage d'un élément de fixation de type vis de fixation destinée à fixer le support d'appareillage électrique à l'élément de réception, avec un élément de montage formé d'une plaquette similaire réalisée en matériau polymère.

De plus, les moyens de coulissement autorisent la mobilité selon ladite direction transverse d'un élément de montage de type « plaquette », y compris lorsque celle-ci est assemblée sur le corps, ce qui facilite le montage et la fixation du support d'appareillage électrique sur l'élément de réception.

D'autres caractéristiques non limitatives et avantageuses du support d'appareillage électrique conforme à l'invention, prises individuellement ou selon toutes les combinaisons techniquement possibles, sont données dans les sous-revendications 2 à 11.

L'invention concerne également un appareillage électrique selon la revendication 12.

### DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 est une vue schématique éclatée en perspective latérale d'un ensemble dans lequel un appareillage électrique selon l'invention comprenant un premier mode de réalisation d'un support d'appareillage électrique selon l'invention, dont un corps reçoit quatre éléments de montage de type « plaquette », est monté dans une boîte électrique au moyen de deux éléments de fixation ;
- la figure 2 est une vue schématique éclatée en perspective avant du support d'appareillage électrique de la figure 1, isolé du reste de l'appareillage électrique ;
- la figure 3 est une vue schématique avant du support d'appareillage électrique de la figure 2 dont les plaquettes sont assemblées le corps ;
- la figure 4 est une vue schématique partielle du support d'appareillage électrique de la figure 2, représentant un logement du corps de ce support d'appareillage électrique ;
- les figures 5 et 6 sont respectivement des vues schématiques en perspective avant et arrière d'une des plaquettes du support d'appareillage électrique de la figure 2 ;
- la figure 7 est une vue schématique d'une des plaquettes du support d'appareillage électrique de la figure 1 en cours de montage sur la boîte électrique de la figure 1, la plaquette étant en position de repos sur ledit support d'appareillage électrique ;
- les figures 8 et 9 sont des vues schématiques arrachées, en perspective latérale, d'une plaquette respectivement en cours d'assemblage et assemblée sur le corps du support d'appareillage électrique de la figure 2 ;
- les figures 10 et 11 sont des vues schématiques avant du support d'appareillage électrique de la figure 3 respectivement en cours de montage et monté sur la boîte électrique de la figure 1 ;
- la figure 12 est une vue schématique éclatée en perspective avant d'un bloc bi-poste dans lequel deux supports d'appareillage électrique selon le premier mode de réalisation de l'invention sont montés dans deux boîtes électriques monoposte accolées, et recouverts par une unique plaque de finition bi-poste (les mécanismes d'appareillage électrique ne sont pas représentés) ;
- les figures 13 et 14 sont des vues schématiques avant du bloc bi-poste de la figure 9, dans lesquelles la plaque de finition n'est pas représentée, les supports d'appareillage électrique étant respectivement non jumelés et jumelés l'un à l'autre ;
- la figure 15 est une vue schématique partiellement éclatée du corps d'un support d'appareillage électrique selon un deuxième mode de réalisation de l'invention dont le corps reçoit deux éléments de montage de type « plaquette » et deux éléments de montage de type « accessoire de griffage » ; et,
- les figures 16 et 17 sont des vues schématiques respectivement avant et en perspective arrière d'un des accessoires de griffage du support d'appareillage électrique de la figure 15 assemblé sur le corps de ce support d'appareillage électrique.

En préliminaire, on notera que les éléments identiques ou similaires des différents modes de réalisation de l'invention ne seront pas décrits à chaque fois et qu'ils porteront les mêmes signes de référence.

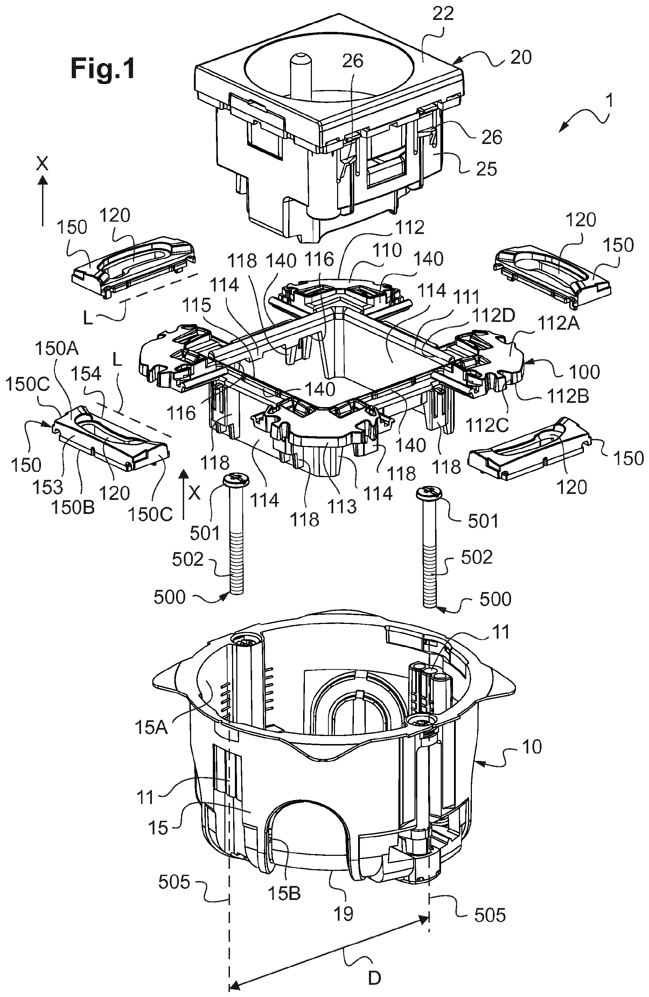

Sur la figure 1, on a représenté un ensemble comportant un appareillage électrique 1 selon l'invention et un élément de réception sur lequel l'appareillage électrique 1 est destiné à être monté et fixé.

Plus précisément, l'appareillage électrique 1 de l'ensemble de la figure 1 comporte un mécanisme d'appareillage électrique 20 et un premier mode de réalisation d'un support d'appareillage électrique 100 selon l'invention.

Ce premier mode de réalisation du support d'appareillage électrique 100 sera décrit ci-dessous en plus grands détails en référence aux figures 1 à 14.

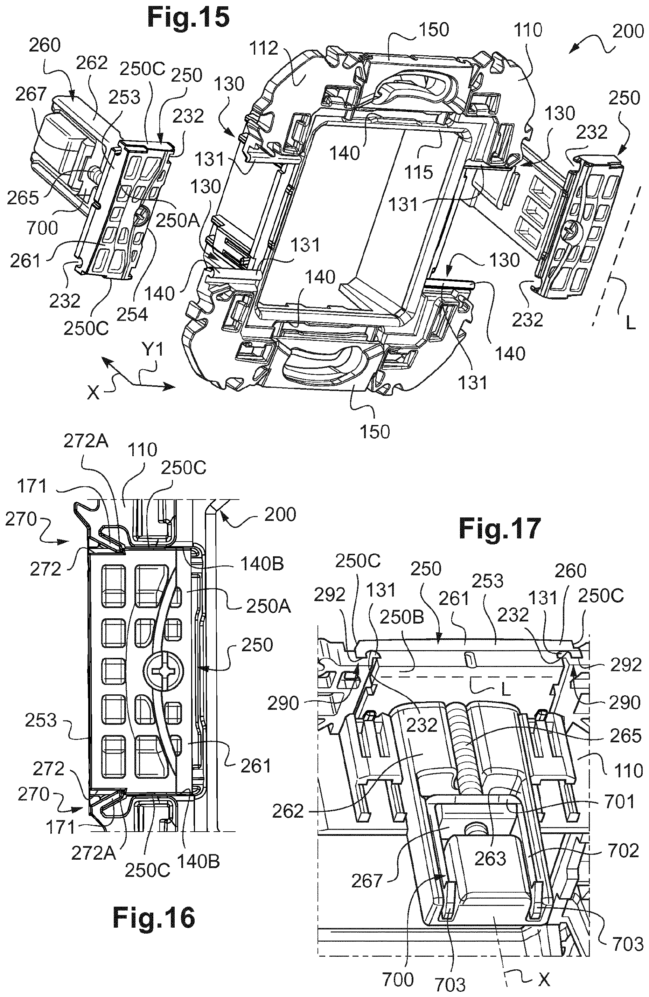

L'appareillage électrique pourrait tout aussi bien comporter le mécanisme d'appareillage électrique 20 et un deuxième mode de réalisation d'un support d'appareillage électrique 200 selon l'invention représenté schématiquement sur les figures 15 à 17.

Dans la suite de la description, pour plus de facilité, le support d'appareillage électrique 100 ; 200 sera appelé support 100 ; 200.

De manière générale, le mécanisme d'appareillage électrique 20 est adapté à être rapporté sur le support 100 ; 200, qui est destiné à être monté et fixé dans l'élément de réception via deux éléments de fixation.

Le mécanisme d'appareillage électrique 20 est ici un mécanisme d'une prise de courant. En variante, le support 100 ; 200 pourrait bien entendu recevoir d'autres mécanismes d'appareillage électrique tels qu'un mécanisme d'interrupteur, d'une prise USB, d'une prise de téléphone, d'une prise TV, ou encore d'une prise Ethernet, par exemple.

Comme le montre la figure 1, ce mécanisme d'appareillage électrique 20 comprend de manière générale un socle 25 en matériau isolant, logeant les composants électriques du mécanisme d'appareillage électrique 20 et enjoliveur 22 donnant la fonction électrique au mécanisme. Ici, l'enjoliveur 22 comporte un puits de réception pour accueillir une fiche électrique. En variante, l'enjoliveur peut comporter une ou plusieurs touches d'interrupteur ou un puits de réception d'un connecteur de téléphone ou USB par exemple.

Comme le montre la figure 1, l'élément de réception est ici une boîte électrique 10. Cette boîte électrique 10 est une boîte d'encastrement à accrocher dans un orifice d'encastrement d'une cloison creuse. En variante, la boîte électrique pourrait également être du type à sceller dans une paroi maçonnée ou à fixer en saillie d'une paroi.

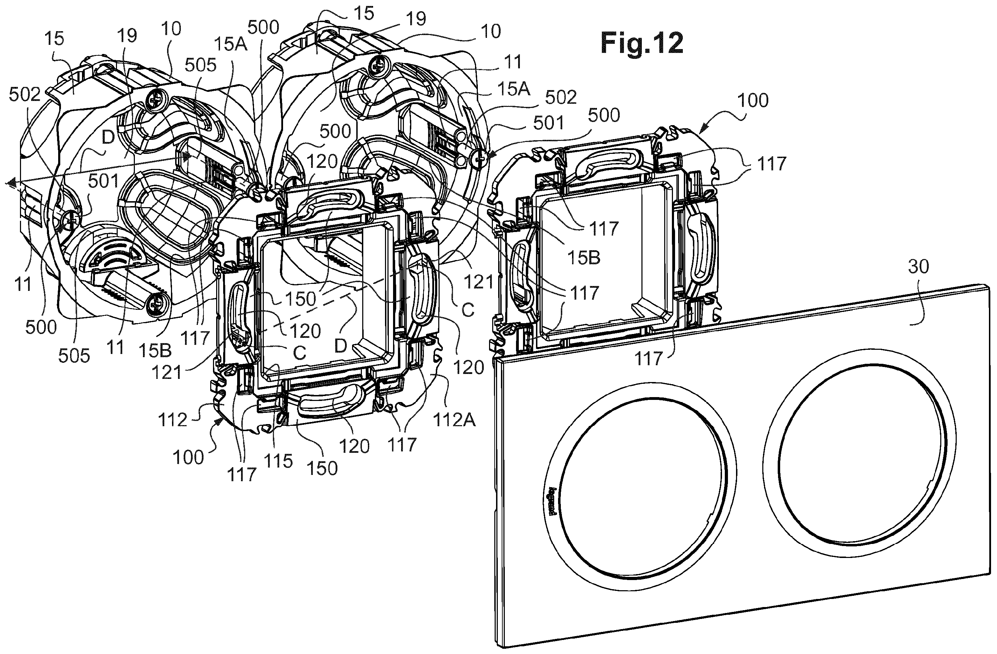

Comme le montre les figures 1 et 12, cette boîte électrique 10 comporte une paroi latérale 15 qui est fermée à l'arrière par une paroi de fond 19 et qui délimite à l'avant une ouverture de réception du mécanisme d'appareillage électrique 20.

Ici, la boîte électrique 10 présente une forme cylindrique, mais elle pourrait présenter une forme différente, notamment parallélépipédique.

Telle que représentée sur les figures 1 et 12, la boîte électrique 10 présente dans sa paroi latérale 15 et dans sa paroi de fond 19 des ouvertures 15B de passage de gaine de cheminement (dans lesquelles peuvent être insérés des fils électriques, des fibres optiques, ...), qui sont initialement obturées par des opercules défonçables.

Tel que représenté sur la figure 1, le premier mode de réalisation du support 100 est monté et fixé dans la boîte électrique 10 via deux vis de fixation 500 constituant les deux éléments de fixation. Ces vis de fixation 500 sont vissées dans deux fûts de vissage 11 diamétralement opposés, portés par une face interne 15A de la paroi latérale 15 de la boîte électrique 10.

Le deuxième mode de réalisation du support 200 représenté sur les figures15 à 17 est monté et fixé dans la boîte électrique 10 via deux griffes de fixation 700 constituant les deux éléments de fixation. Ces griffes de fixation 700 comportent chacune au moins une extrémité libre pointue, tournée vers la face interne 15A de la paroi latérale 15 de la boîte électrique 10 et adaptée à coopérer à retenue avec la paroi latérale 15 de la boîte électrique 10.

Quel que soit le mode de réalisation envisagé, la boîte électrique 10 est prévue pour être rapportée dans une paroi murale, de telle manière que son ouverture avant affleure la face avant de la paroi murale. Selon le premier mode de réalisation du support 100, la boîte électrique 10 est outre rapportée dans la paroi murale de telle sorte que les axes de fixation 505 des deux vis de fixation 500 se retrouvent, autant que possible, dans un même plan horizontal.

Dans la description, les termes « avant » et « arrière » seront alors utilisés par rapport à la direction du regard de l'utilisateur tourné vers l'appareillage électrique monté dans la paroi. Ainsi, l'avant d'un élément désignera le côté de cet élément qui est tourné vers l'utilisateur et l'arrière désignera le côté opposé.

Comme le montrent les figures 1 et 15, le support 100 ; 200 comporte un corps 110 en matériau isolant dans lequel est prévu au moins un logement 140, et un élément de montage 150 ; 250 reçu dans ledit logement 140 pour la fixation dudit support 100 ; 200 sur la boîte électrique 10. De préférence, il est prévu au moins deux logements alignés dos-à dos sur le corps.

Plus précisément, le corps 110 du support 100 ; 200 comporte ici quatre logements 140, deux à deux alignés sur le corps 110. Ainsi, les logements 140 sont deux à deux dos-à-dos, chaque logement 140 s'ouvrant vers l'extérieur du support 100 ; 200.

Chaque logement 140 est adapté à accueillir un élément de montage 150 ; 250. Deux des éléments de montage 150 ; 250 reçus dans les logements 140, en vis-à-vis sur le corps 110, logent chacun un des éléments de fixation 500 ; 700 destiné à fixer le support 100 ; 200 sur la boîte électrique 10. Ainsi, selon le premier mode de réalisation (figure 1), deux éléments de montage 150 en vis-à-vis loge chacun une vis de fixation 500 destinée à être vissée dans un des fûts de vissage 11 de la boîte électrique 10, tandis que selon le deuxième mode de réalisation (figure 15), deux éléments de montage 250 en vis-à-vis loge chacun une griffe de fixation 700 destinée à s'accrocher à la paroi latérale 15 de la boîte électrique 10.

Chaque élément de montage 150 ; 250 forme une pièce séparée du corps 110 du support 100 ; 200 de sorte que ledit corps 110 du support 100 ; 200 et chaque élément de montage 150 ; 250 peuvent être réalisés dans des matériaux distincts.

Ici, le corps 110 du support 100 ; 200 est moulé dans une matière plastique.

Le corps 110 du support 100 ; 200 est identique dans les deux modes de réalisation représentés respectivement sur les figures 1 à 14 et 15 à 17. Il sera préférentiellement décrit en référence aux figures 1 à 14 qui illustrent le premier mode de réalisation, dans la mesure où ces figures sont plus détaillées.

Comme le montre plus précisément la figure 1, le corps 110 du support 100 ; 200 forme un cadre 112 prolongé vers l'arrière par quatre parois tombantes 114.

Le cadre 112 du corps 110 est globalement plat et s'étend globalement dans un plan moyen. Plus précisément, comme le montre la figure 1, le cadre 112 présente ici une forme carré, avec quatre branches. Il comporte une face avant 112A et une face arrière 112B reliées entre elles par une tranche externe 112C et une tranche interne 112D. Les tranches externe et interne 112C, 112D forment respectivement un bord périphérique externe 113 et un bord périphérique interne 111 du cadre 112 du corps 110.

Le bord périphérique interne 111 du cadre 112 délimite une ouverture d'accueil 115 d'un ou plusieurs mécanismes d'appareillage électrique 20 tels que décrits précédemment (figure 1). L'ouverture d'accueil 115 est globalement comprise dans le plan moyen dans lequel s'étend le cadre 112.

L'ouverture d'accueil 115 peut accueillir un socle de largeur « 2 modules » de mécanisme d'appareillage électrique ou deux socles de largeur « 1 module » de mécanismes d'appareillage électrique. Dans l'exemple représenté sur la figure 1, l'ouverture d'accueil 115 accueille le socle 25 de largeur « 2 modules » du seul mécanisme d'appareillage électrique 20.

Cette ouverture d'accueil 115 présente ici, comme le cadre 112, une forme carrée et autorise le passage du socle 25 du mécanisme d'appareillage électrique 20.

Comme le montre la figure 1, les quatre parois tombantes 114 du corps 110 s'étendent à partir de la face arrière 112B du cadre 112 et bordent l'ouverture d'accueil 115. Leurs faces internes, tournées vers l'ouverture d'accueil 115, prolongent le bord périphérique interne 111 du cadre 112. Ces parois tombantes 114 s'étendent sensiblement perpendiculairement au plan moyen du cadre 112.

Plus précisément, ici, les parois tombantes 114 délimitent un puits de réception du support 100 ; 200 adapté à accueillir le socle 25 du mécanisme d'appareillage électrique 20. Le socle 25 et le puits de réception du support 100 ; 200 sont de forme complémentaire, ici globalement parallélépipédique, de sorte que lorsque le socle 25 du mécanisme d'appareillage électrique 20 est emboîté dans ce puits de réception, l'enjoliveur 22 du mécanisme d'appareillage électrique 20 ferme l'ouverture d'accueil 115 du support 100 ; 200.

Pour le montage du socle 25 du mécanisme d'appareillage électrique 20 sur le support 100 ; 200, ce support 100 ; 200 comporte des moyens de montage destinés à coopérer avec des moyens de montage complémentaires portés par le socle 25 du mécanisme d'appareillage électrique 20.

Les moyens de montage sont prévus à proximité du bord périphérique interne 111 du cadre 112 délimitant ladite ouverture d'accueil 115. Ici, les moyens de montage sont plus précisément prévus dans deux parois tombantes 114 opposées. Ces moyens de montage sont des moyens d'encliquetage.

Comme le montre la figure 1, les deux parois tombantes 114 opposées portant les moyens de montage sont évidées et le bord libre de ces deux parois tombantes 114 opposées comporte des encoches d'encliquetage 116 dont les tranches forment des rebords d'accrochage sur lesquels sont adaptées à s'accrocher des dents d'encliquetage 26 faisant saillie de deux faces latérales opposées du socle 25 (figure 1).

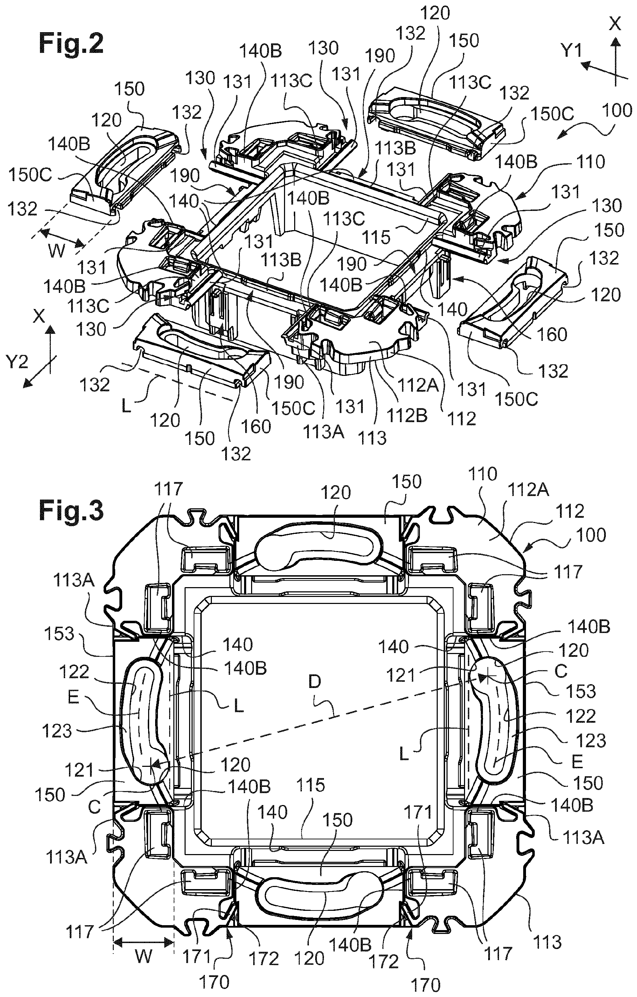

Comme le montrent mieux les figures 3 et 12, il est prévu sur le cadre 112 du corps 110 des moyens d'assemblage 117 d'une plaque de finition 30 (figure 12). Ces moyens d'assemblage 117 sont accessibles en face avant 112A dudit cadre 112. Il comprennent ici des moyens d'encliquetage, notamment une pluralité de logements muni chacun d'une dent d'accrochage adaptée à coopérer à retenue avec des moyens d'accrochage complémentaire prévus en face arrière de la plaque de finition 30.

Comme le montrent les figures 1 et 15, chacun des logements 140 recevant un des éléments de montage 150 ; 250 est ménagé en renfoncement dans ledit cadre 112.

Plus précisément, comme le montre la figure 2, chaque logement 140 est délimité par le bord périphérique externe 113 dudit cadre 112. Ainsi, chaque logement 140 forme ici une découpe dans la branche correspondante du cadre 112.

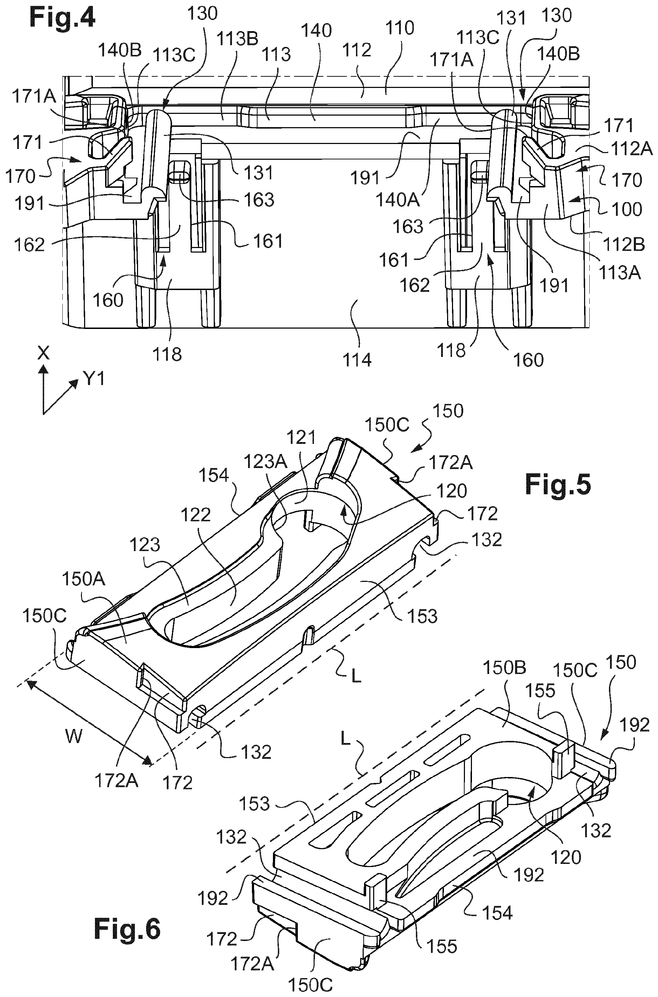

Comme le montre bien les figures 2 et 4, dans chaque branche, le bord périphérique externe 113 du cadre 112 du corps 110 comporte alors une première portion 113A à partir de laquelle est formé le logement, une deuxième portion 113B qui s'étend en retrait par rapport à ladite première portion, à distance et globalement parallèlement à ladite première portion 113A, et deux autres portions 113C qui relient, globalement perpendiculairement, lesdites première et deuxième portions 113A,113B.

Ainsi, comme le montre bien la figure 4, chaque logement 140 est globalement de forme rectangulaire et présente trois côtés fermés et un quatrième côté ouvert. Plus précisément, le logement 140 présente, d'une part, deux bords latéraux 140B opposés et parallèles, formés par lesdites autres portions 113C du bord périphérique externe 113, et d'autre part, un fond 140A reliant lesdits bords latéraux 140B, ce fond 140A étant formé par ladite deuxième portion 113B du bord périphérique externe 113. L'entrée du logement 140 est délimitée entre lesdits bords latéraux 140B opposés, à l'opposé dudit fond 140A, c'est-à-dire entre les deux premières portions 113A du bord périphérique externe 113.

Le fait que le logement 140 soit ouvert sur son quatrième côté facilite l'assemblage de l'élément de montage 150 ; 250 dans le logement 140 correspondant.

Comme le montrent les figures 1, 2 et 4, chaque logement 140 comporte une partie traversante débouchant, d'un côté, sur la face avant 112A dudit cadre 112, et, de l'autre côté, sur la face arrière 112B de ce cadre 112.

Comme le montrent plus particulièrement les figures 1, 2, 4, 8 et 9, chaque logement 140 est ici quasi-intégralement ouvert selon une direction X sensiblement perpendiculaire à la face avant 112A du cadre 112 du corps 110 et au plan moyen dans lequel s'étend le cadre 112. Autrement dit, dans le plan moyen dans lequel s'étend le cadre 112, la surface du logement 140 est très majoritairement occupée par la partie traversante de ce logement 140.

Le support 100 ; 200 est en outre muni de moyens d'assemblage du corps 110 et de l'élément de montage 150 ; 250.

Plus précisément, comme le montrent les figures 2, 8 et 9, les moyens d'assemblage comportent des moyens de coulissement réciproques entre le corps 110 et l'élément de montage 150 ; 250. Ces moyens de coulissement réciproques comportent plus particulièrement des moyens de coulissement 130 appartenant au corps 110 du support 100 ; 200, ainsi que des moyens de coulissement complémentaires appartenant à chaque élément de montage 150 ; 250. Bien entendu, les moyens de coulissement 130 du corps 110 du support 100 sont adaptés à coopérer avec les moyens de coulissement complémentaires de chaque élément de montage 150 ; 250.

De manière remarquable, comme le montrent les figures 2 et 15, chaque logement 140 comporte les moyens de coulissement 130 et ceux-ci autorisent le coulissement dudit élément de montage 150 ; 250 dans le logement 140 correspondant, en translation selon une direction transverse Y1, Y2 globalement perpendiculaire à la partie du bord périphérique interne 111 du cadre 112 la plus proche dudit logement 140.

La direction de coulissement Y1, Y2 est ainsi globalement perpendiculaire à la branche correspondante du cadre 112, et s'étend dans le plan moyen d'extension du cadre 112.

Les moyens de coulissement 130 autorisent un assemblage et un désassemblage aisé de l'élément de montage 150 ; 250 dans le logement 140, quel que soit cet élément de montage 150 ; 250.

Comme le montrent bien les figures 2 et 4, les moyens de coulissement 130 du corps 110 sont portés par les bords latéraux 140B opposés et parallèles de chaque logement 140. Ils s'étendent à l'intérieur du logement 140, le long de chaque bord latéral 140B du logement 140.

Ici, comme le montrent les figures 2, 4, 8 et 9, les moyens de coulissement 130 dans chaque logement 140 comprennent deux coulisseaux de guidage 131 qui s'élèvent en saillie vers l'avant à partir d'un trottoir d'appui 191 de faible largeur (bien visible sur la figure 4) prévu le long de chaque bord latéral 140B du logement 140, à proximité de la face arrière 112B du cadre 112.

Avantageusement, les moyens de coulissement 130 du corps 110 présentent en outre un effet de solidarisation de l'élément de montage 150 ; 250 sur ledit corps 110. Ici, comme le montre bien la figure 4, l'extrémité libre de chaque coulisseau de guidage 131 présente une forme particulière qui permet de retenir l'élément de montage 150 ; 250 selon la direction X perpendiculaire à la face avant 112A du cadre 112. Ici, la forme particulière de l'extrémité libre du coulisseau de guidage 131 est celle d'un quart de cylindre s'étendant comme un bec vers l'intérieur du logement 140. Les moyens de coulissement 130 solidarisent ledit élément de montage 150 ; 250 au corps 110 du support 100 ; 200, et facilitent ainsi le montage et la fixation dudit support 100 ; 200 sur la boîte électrique 10.

Comme le montrent bien les figures 2, 5, 6, 15 et 17, quel que soit le mode de réalisation envisagé, les moyens de coulissement complémentaires de chaque élément de montage 150 ; 250 sont prévus à la périphérie dudit élément de montage 150 ; 250. Plus précisément, chaque élément de montage 150 ; 250 porte le long de deux bords d'extrémité 150C ; 250C, une coulisse 132 ; 232 adaptée à coopérer avec lesdits coulisseaux de guidage 131 du logement 140. Chaque coulisse 132 ; 232 s'étend à proximité de chaque bord d'extrémité 150C ; 250C de l'élément de montage 150, parallèlement à chaque bord d'extrémité 150C ; 250C. Chaque coulisse 132 ; 232 est ici ménagée en creux selon une forme complémentaire de celle du coulisseau de guidage 131 correspondant, dans une face arrière 150B ; 250B dudit élément de montage 150 ; 250. Elle débouche à la fois sur la face arrière 150B ; 250B, sur un bord interne 154 ; 254 (qui est tourné vers le fond 140A du logement 140 donc non visible sur la figure 17) et sur un bord externe 153 ; 253 dudit élément de montage 150 ; 250.

Les moyens d'assemblage du support 100 ; 200 comportent en outre ici des moyens de blocage 170 ; 270 réciproques entre le corps 110 du support 100 ; 200 et l'élément de montage 150 ; 250. Les moyens de blocage 170 ; 270 sont interposés entre le corps 110 du support 100 ; 200 et l'élément de montage 150 ; 250 pour empêcher ledit élément de montage 150 ; 250, une fois assemblé sur le corps 110, de sortir de son logement 140.

Plus précisément, comme le montrent les figures 3, 7, 8, 9, et 16, les moyens de blocage 170 ; 270 comportent des moyens de blocage externes du corps 110 adaptés à coopérer avec des moyens de blocage complémentaires de l'élément de montage 150 ; 250.

En particulier, comme le montrent bien les figures 3, 4, 7, 8, 9 et 16, ici, les moyens de blocage externe du corps 110 comportent une patte flexible 171 découpée dans chacun des bords latéraux 140B opposés de chaque logement 140, de part et d'autre de l'entrée dans chaque logement 140. Chaque patte flexible 171 fait légèrement saillie vers l'intérieur du logement 140, dans une région avant du support 100 ; 200.

Comme le montrent bien les figures 3, 5, 6, 7, 8, 9 et 16 les moyens de blocage complémentaires de chaque élément de montage 150 ; 250 comportent quant à eux une encoche 172 ; 272 découpée dans chaque bord d'extrémité 150C ; 250C dudit élément de montage 150 ; 250. Chaque encoche 172 ; 272 débouche dans une région avant et externe seulement de ce bord d'extrémité 150C ; 250C, d'une part, sur une face avant 150A ; 250A dudit élément de montage 150 ; 250, et, d'autre part, sur le bord externe 153 ; 253 dudit élément de montage 150 ; 250.

Comme le montrent bien les figures 2 et 17, le support 100 ; 200 comporte en outre des moyens d'appui réciproques 190 ; 290 entre ledit corps 110 et ledit élément de montage 150 ; 250. Comme il sera détaillé ci-après, la fixation de l'élément de fixation 500 ; 700 dans la boîte électrique 10 plaque l'élément de montage 150 ; 250 contre le corps 110 du support 100 ; 200 de sorte que ledit corps 110 est lui-même plaqué contre la face avant de la paroi d'installation dans laquelle est montée la boîte électrique 10, par un effet de bride.

Plus précisément, comme le montrent les figures 4, 6 et 17, les moyens d'appui réciproques 190 ; 290 comportent le trottoir d'appui 191 du corps 110 à partir duquel s'étendent les coulisseaux de guidage 131 dudit corps 110, ainsi qu'une zone d'appui complémentaire 192 ; 292 portée par l'élément de montage 150 ; 250.

En particulier, le trottoir d'appui 191 du corps 100 est adapté à s'appliquer contre la zone d'appui complémentaire 192 ; 292 dudit élément de montage 150 ; 250.

Comme le montre bien la figure 4, le trottoir d'appui 191 du corps 110 est ménagé dans chaque logement 140 et s'étend à partir de la face arrière 112B du cadre 112, tout le long des bords latéraux 140B opposés et du fond 140A du logement 140, vers l'intérieur dudit logement 140. Le trottoir d'appui 191 s'étend en dehors de la zone de coulissement, en particulier le long des bords latéraux 140B opposés où il s'étend entre lesdits bords latéraux 140B et les moyens de coulissement 130. Le trottoir d'appui 191 présente une largeur limitée de manière à maximiser la partie traversante du logement 140.

Comme le montrent les figures 6 et 17, la zone d'appui complémentaire 192 ; 292 de l'élément de montage 150 ; 250 est quant à elle formée à l'arrière de l'élément de montage 150 ; 250. Elle est plus particulièrement disposée en retrait par rapport à la face arrière 150B ; 250B dudit élément de montage 150 ; 250 et s'étend le long des bords d'extrémité 150C ; 250C et du bord interne 154 dudit élément de montage 150 ; 250 (visible sur la figure 6 uniquement).

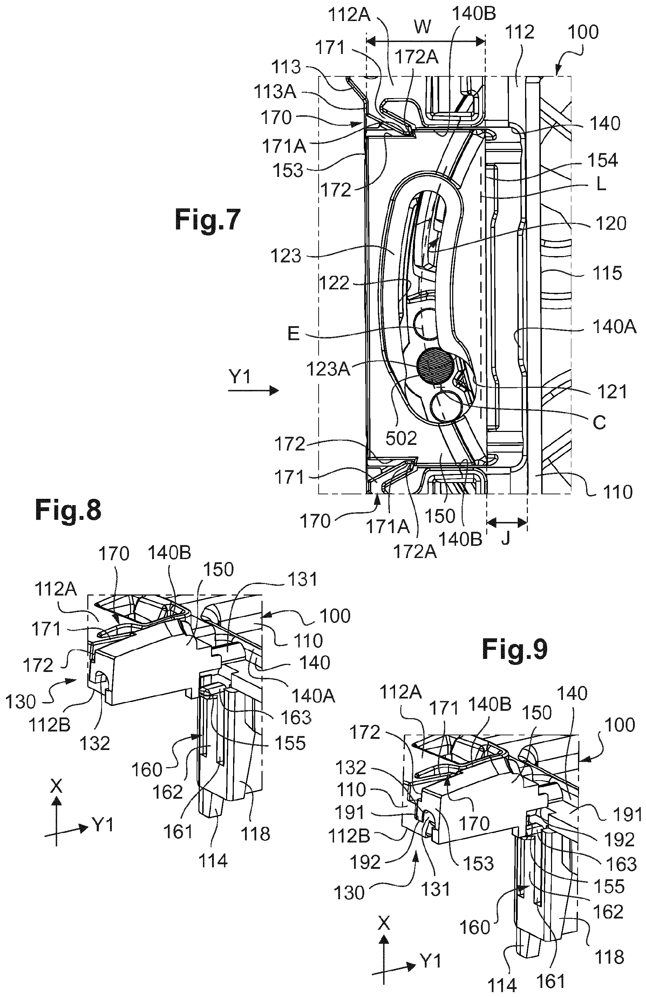

Comme le montrent les figures 8, 9 et 15, pour insérer l'élément de montage 150 ; 250 dans son logement 140, il suffit de faire coïncider chaque coulisseau de guidage 131 du logement 140 avec la coulisse 132 ; 232 correspondante de l'élément de montage 150 ; 250, depuis l'entrée du logement 140, et de pousser l'élément de montage 150 ; 250 en direction du fond 140A du logement 140, selon ladite direction transverse Y1 de coulissement. Ce faisant, les deux pattes flexibles 171 disposées à l'entrée du logement 140, en regard l'une de l'autre, sont repoussées par les bords d'extrémité 150C ; 250C dudit élément de montage 150 ; 250, en direction du bord latéral 140B du logement 140 à partir de laquelle s'étend chacune de ces pattes flexibles 171. Une fois l'élément de montage 150 ; 250 suffisamment enfoncé dans le logement 140, chaque patte flexible 171 reprend sa position initiale et s'emboîte dans l'encoche 172 de l'élément de montage 150 ; 250 prévue à cet effet, en général avec un « clic » sonore qui indique à l'installateur l'insertion correcte de l'élément de montage 150 ; 250 sur le corps 110.

Comme le montrent les figures 7 et 16, le blocage de l'élément de montage 150 ; 250 sur le corps 110 est opéré par l'extrémité libre 171A de la patte flexible 171 du corps 110 (figure 4) qui bute contre le fond 172A ; 272A de l'encoche 172 ; 272 de chaque élément de montage 150 ; 250 (figures 5, 6 et 16). Une fois l'élément de montage 150 ; 250 assemblé sur le corps 110 du support 100 ; 200, sa face avant 150A ; 250A affleure la face avant 112A du cadre 112.

Comme le montrent les figures 9 et 17, lorsque l'élément de montage 150 ; 250 est assemblé sur le corps du support 100 ; 200, la zone d'appui complémentaire 192 ; 292 de l'élément de montage 150 ; 250 prend au moins partiellement appui sur le trottoir d'appui 191 du corps 110.

Pour désassembler l'élément de montage 150 ; 250 reçu dans le logement 140 du corps 110 du support 100 ; 200, il suffit de repousser chaque patte flexible 171 du corps 110 vers le bord latéral 140B du logement 140 à partir de laquelle elle s'étend et de tirer sur l'élément de montage 150 ; 250, vers l'extérieur du corps 110, selon la direction transverse Y1, Y2 de coulissement.

Il est ainsi possible de changer facilement un élément de montage pour un autre élément de montage. Par exemple, il est possible de changer un premier élément de montage pour un deuxième élément de montage similaire réalisé dans un matériau différent. Il est aussi possible de changer un élément de montage d'un premier type, par exemple une plaquette, pour un élément de montage d'un autre type, par exemple un accessoire de griffage, pour autant que deux éléments de montage en vis-à-vis par rapport à l'ouverture d'accueil soient toujours deux éléments de montage du même type.

Le support 100 selon le premier mode de réalisation, représenté sur les figures 1 à 14, comporte pour élément de montage au moins une plaquette 150 munie d'une ouverture traversante 120.

Ici, comme le montrent les figures 1 à 3 et 10 à 12, le support 100 comporte plus particulièrement quatre plaquettes 150 disposées deux à deux en vis-à-vis sur le corps 110.

Ici, chaque plaquette 150 est réalisée en un matériau polymère rigide. Par exemple, elle peut être moulée en un matériau polymère rigide tel qu'un matériau polymère chargé en fibres de verre ou un ABC (Acrylonitrile Butadiène Styrène), tandis que le corps 110 du support 100 est moulé en un matériau polymère isolant moins couteux. En variante, les plaquettes pourraient être réalisées en métal. On pourrait aussi prévoir de mouler les plaquettes 150 dans un matériau polymère d'une première couleur et le corps du support dans un matériau polymère d'une deuxième couleur.

Les ouvertures traversantes 120 de deux plaquettes 150 diamétralement opposées de part et d'autre de l'ouverture d'accueil 115 sont destinées au passage de la vis de fixation 500 correspondante permettant de fixer le support 100 sur la boîte électrique 10. Grâce aux quatre plaquettes 150 reçus sur le corps 110, le montage du support 100 sur la boîte électrique 10 peut être réalisé pour différentes orientations du mécanisme d'appareillage électrique 20. Ainsi, ici, le montage du support 100 sur la boîte électrique 10 n'impose pas d'orientation à la prise de courant par rapport à la verticale ou à l'horizontale de la paroi d'installation.

Comme le montrent plus précisément les figures 1, 2, 5 et 6, chaque plaquette 150 présente, dans cet exemple, une forme globalement parallélépipédique aplatie, allongée selon une direction longitudinale L. Telle que représentée plus précisément sur les figures 1, 5 et 6, chaque plaquette 150 comporte deux faces principales opposées, à savoir la face avant 150A et la face arrière 150B, reliées entre elles par quatre bords latéraux 150C, 153, 154 constituant la tranche de la plaquette 150. Le bord interne 154 de la tranche de la plaquette 150 est destiné à être tourné vers l'ouverture d'accueil 115 du support 100, tandis que le bord externe 153 de la tranche de la plaquette 150, opposé audit bord interne 154, est destiné à être tourné vers l'extérieur du support 100. Les bords d'extrémité 150C de la plaquette 150 relient entre eux lesdits bords interne et externe 154, 153.

Ainsi, comme le montrent les figures 2, 3 et 7, chaque plaquette 150 présente une forme globalement complémentaire de la forme du logement 140, à ceci près que les bords latéraux 140B opposés dudit logement 140 s'étendent sur une distance plus longue que les bords d'extrémité 150C de la plaquette 150 formant « la largeur W » de la plaquette 150.

L'ouverture traversante 120 de chaque plaquette 150 traverse ladite plaquette 150 de part en part et débouche à la fois sur la face avant 150A et sur la face arrière 150B de ladite plaquette 150.

Comme le montrent les figures 3, 7 et 10, chaque ouverture traversante 120 présente ici une forme globalement allongée et s'étend selon la direction longitudinale L. Ici, pour chaque ouverture traversante 120, la direction longitudinale L est parallèle à la branche du cadre 112 dans laquelle est reçue la plaquette 150 correspondante. Les quatre ouvertures traversantes 120 sont chacune disposées globalement au centre de l'une des quatre branches du cadre 112 du support 100.

Comme le montrent plus particulièrement les figures 3, 7, 10 et 11 chaque ouverture traversante 120 présente ici une forme en trou de serrure, c'est-à-dire présentant une majeure partie allongée 122 à l'extrémité de laquelle il est prévue une partie circulaire 121.

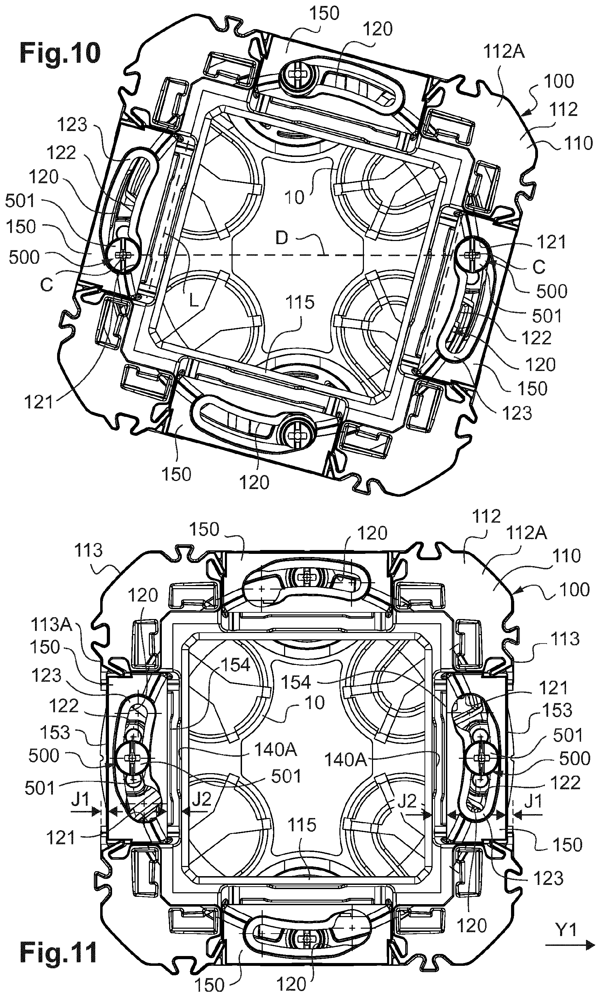

En particulier, chaque partie circulaire 121 autorise le passage de la tête de vis 501 (figure 10), et la partie allongée constitue un trou oblong 122 prolongeant ladite partie circulaire 121. La largeur du trou oblong 122 est inférieur au diamètre de la partie circulaire 121 pour autoriser le passage du corps de vis 502 seulement (figures 7 et 11).

Ici, comme le montent les figures 3, 7, 10 et 11, le trou oblong 122 est délimité par un trottoir 123 s'étendant en retrait par rapport à la face avant 112A du cadre 112 du corps 110 du support 100 pour recevoir, en appui, la tête de vis 501 (figure 11). Ainsi, lorsque le support 100 est fixé sur la boîte électrique 10 par le serrage de la vis de fixation 500, la face avant de ladite tête de vis 501 affleure la face avant 112A du cadre 112 du support 100 (figure 11).

Tel que représenté sur les figures 3 et 7, le trou oblong 122 de l'ouverture traversante 120 s'étend selon un grand axe E courbé, dont la concavité est tournée vers l'ouverture d'accueil 115 du support 100. Grâce à la courbure du grand axe E du trou oblong 122, le support 100 peut être pivoté angulairement par le coulissement conjoint de chaque corps de vis 502 dans le trou oblong 122 correspondant, ce qui permet un rattrapage angulaire dudit support 100 lors de sa fixation sur la boîte électrique 10.

L'ouverture traversante 120 de la plaquette 150 reçue dans ledit logement 140 coïncide avec la partie partie traversante dudit logement 140 pour permettre le passage de la vis de fixation 500. L'ouverture traversante 120 de la plaquette 150 s'étend à distance de toutes les parois du corps 110 du support 100. Autrement dit, l'ouverture traversante 120 de la plaquette 150 est intégralement disposée en dehors du trottoir d'appui 191 du corps 110, à distance de ce dernier.

La longueur de chaque bord latéral 140B du logement 140 étant supérieure à la longueur de chaque bord d'extrémité 150C de la plaquette 150, les moyens de coulissement 130 du corps 110 autorisent un mouvement de translation de ladite plaquette 150 selon la direction transverse Y1, Y2 de coulissement, y compris lorsque la plaquette 150 est assemblée sur le corps 110. Autrement dit, les moyens de coulissement 130 du corps 110 reçoivent la plaquette 150 en coulissement pour son assemblage sur le corps 110 du support 100, et une fois la plaquette 150 assemblée sur le corps 100, celle-ci est encore mobile en coulissement à l'intérieur du logement 140. Ainsi, lesdits moyens de coulissement 130 du corps 110 autorisent un mouvement de translation relatif de ladite plaquette 150 par rapport au cadre 112 du support 100, selon la direction transverse Y1, Y2 de coulissement propre à chaque logement 140, globalement perpendiculaire à la direction longitudinale L de la plaquette 150 (figure 2).

Autrement dit, chaque plaquette 150 assemblée sur le corps 110 du support 100 peut être déplacée selon la direction transverse Y1, Y2 de coulissement propre à chaque logement 140 (figure 2), entre le fond 140A du logement 140 et la première portion 113A du bord périphérique externe 113 du cadre 112. Cette direction transverse Y1, Y2 de coulissement s'étend sensiblement perpendiculairement à la branche du cadre 112 dans laquelle est ménagé le logement 140 correspondant et donc perpendiculairement aux première et deuxième portions 113A, 113B du bord périphérique externe 113 correspondant.

Ainsi, la plaquette 150 est mobile dans ledit logement 140 du support 100, entre une position extrême externe proche du bord périphérique externe 113 du cadre 112 et une position extrême interne proche du bord périphérique interne 111 du cadre 112. Plus précisément, la position extrême externe de la plaquette 150 correspond à une position dans laquelle le bord externe 153 de la tranche de la plaquette 150 s'étend globalement dans l'alignement de la première portion 113A du bord périphérique externe 113 du cadre 112, et la position extrême interne de la plaquette 150 correspond à une position dans laquelle le bord interne 154 de la tranche de la plaquette 150 est en contact avec le fond 140A du logement 140.

Cet agencement offre un degré de liberté supplémentaire pour agencer le support 100 sur la boîte électrique 10.

Comme le montrent les figures 2, 4, 8, et 9, le premier mode de réalisation du support 100 comporte en outre des moyens de rappel élastique 160 intervenant entre chaque plaquette 150 et ledit corps 110 du support 100 pour rappeler chaque plaquette 150 dans une position de repos prédéterminée.

Comme le montrent les figures 2, 4, 8 et 9, les moyens de rappel élastique 160 sont ici portés par le corps 110 du support 100 et prennent appui sur une surface d'appui 155 de ladite plaquette 150 (surface d'appui 155 bien visible sur les figures 6, 8 et 9). En variante, les moyens de rappel pourraient très bien être portés par la plaquette et prendre appui sur une surface d'appui du corps.

Plus précisément, les moyens de rappel élastique 160 s'étendent ici à proximité de ou dans chaque logement 140.

Ici, les moyens de rappel élastique 160 viennent de formation avec le corps 110 du support 100. Ils sont donc moulés en matière plastique, comme le corps 110. Leur propriété de « rappel » leur est notamment conférée par le matériau utilisé pour leur fabrication, leur forme, leur épaisseur et leur raideur.

En particulier, comme le montrent les figures 4, 8 et 9, les moyens de rappel élastique 160 comportent ici deux lames ressort 161 adaptées à agir sur chaque plaquette 150. Chaque lame ressort 161 est découpée dans un montant 118 situé le long de la paroi tombante 114 correspondante du corps 110 du support 100. Les montants 118 sont bien visibles sur la figure 1 et s'étendent chacun selon la direction X, à l'extérieur de chaque paroi tombante 114.

Telle que représentée sur les figures 4, 8 et 9, chaque lame ressort 161 s'étend principalement selon la direction X, à l'arrière de la face arrière 112B du cadre 112, dans une région située globalement au droit de chaque coulisseau de guidage 131 ménagé dans le logement 140. Chaque lame ressort 161 comporte une jambe 162 découpée dans le montant 118 et terminée à l'avant par une extrémité libre formant un pied 163 adapté à prendre appui sur la surface d'appui 155 de la plaquette 150. L'extrémité arrière de la jambe 162 s'étend à proximité du bord libre du montant 118 dans lequel la lame ressort 161 est découpée.

Chaque lame ressort 161 est ainsi déformable selon la direction transverse Y1, Y2 de coulissement associée au logement 140 dans lequel est logée la plaquette 150 avec laquelle elle interagit.

Comme le montre la figure 9, lorsque la plaquette 150 est assemblée dans le logement 140 du support 100, en position de repos dans ce logement 140, le pied 163 de chaque lame ressort 161 de ce logement 140 est au contact de la surface d'appui 155 correspondante de la plaquette 150, et la lame ressort 161 est elle-même en position de repos.

Ici, comme le montrent les figures 3 et 7, lorsque la plaquette 150 est en positon de repos, elle adopte la position extrême externe, de sorte que le bord externe 153 de sa tranche prolonge de manière rectiligne le bord périphérique externe 113 dudit cadre 112, au débouché du logement 140. En d'autres termes, en position de repos, la plaquette 150 est poussée au maximum vers l'extérieur du support 100, de sorte que son bord externe 153 s'étend dans le même plan la première portion 113A du bord périphérique 113 de la branche correspondante du cadre 112.

Dans cette position de repos, l'extrémité libre 171A de la patte flexible 171 des moyens de blocage 170 est en butée contre le fond 172A de l'encoche 172 de la plaquette 150.

Lorsque la plaquette est en position de repos, il existe alors un jeu J (figure 7) de l'ordre de quelques millimètres, par exemple égal à 2 millimètres, entre le bord interne 154 de la tranche de la plaquette 150 et le fond 140A du logement 140. Ce jeu J correspond à la course totale de coulissement possible de la plaquette 150 dans son logement 140, selon la direction transverse Y1, Y2 de coulissement associée au logement 140.

Depuis sa position de repos, la plaquette 150 peut ainsi être poussée vers l'intérieur du support 100, c'est-à-dire vers le fond 140A du logement 140, au maximum jusqu'à la position extrême interne. Lors de ce déplacement de la plaquette 150, les surfaces d'appui 155 de la plaquette 150 exercent une pression sur le pied 163 de chaque lame ressort 161, ce qui a pour effet de contraindre chaque lame ressort 161 en dehors de sa position de repos. Les lames ressorts 161 tendent alors à revenir à leur position d'équilibre et exercent ce faisant, via leur pied 163, une force de poussée contre la plaquette 150 pour la ramener dans sa position de repos.

Les moyens de blocage 170 du support 100 empêchent le désassemblage involontaire de la plaquette 150 et du corps 110, malgré l'action des lames ressort 161. Ils forment ainsi une butée de positionnement pour la plaquette 150 repoussée en position de repos, de sorte que ladite plaquette 150 ne peut pas être repoussée vers l'extérieur du corps 110 du support 100 au-delà de cette butée.

Lorsque le support 100 est isolé de la boîte électrique 10, les plaquettes 150 du support 100 sont maintenues en position de repos par l'effet des lames ressort 161.

Comme le montrent les figures 3 et 10, deux plaquettes 150 en vis-à-vis et en position de repos dans leur logement 140 respectifs sont telles que les centres C des parties circulaires 121 de leurs ouvertures traversantes 120 sont distants l'un de l'autre d'une distance prédéterminée égale à l'entraxe D séparant les deux fûts de vissage 11 des vis de fixation 500 dans la boîte électrique 10 (figures 1, 10 et 12). Ici l'entraxe D est égal à 60 millimètres.

Ainsi, grâce à l'invention, le montage du support 100 sur la boîte électrique 10 est facilité puisque les plaquettes 150 maintenues dans leur position de repos respective lorsque le support 100 est isolé de la boîte électrique 10, sont alors automatiquement distantes d'un espacement égal à celui séparant les axes de fixation 505 des vis de fixation 500 déjà montées sur la boîte électrique 10.

Comme le montrent les figures 10 et 11, pour monter le support 100 sur la boîte électrique 10, un utilisateur pivote légèrement ledit support 100 de manière à amener les partie circulaires 121 des ouvertures traversantes 120 de deux plaquettes 150 en face des vis de fixation 500 préalablement vissées sur la boîte électrique 10 (figure 10). Une fois la tête de vis 501 de chaque vis de fixation 500 insérée dans la partie circulaire 121 de l'ouverture traversante 120, l'utilisateur fait pivoter le support 100 en faisant coulisser le corps de vis 502 de chaque vis de fixation 500 dans le trou oblong 122 correspondant (figure 11). Ce pivotement a pour but de redresser le support 100, généralement jusqu'à ce que deux branches opposées du cadre 112 s'étendent sensiblement parallèlement à la droite passant par les centres des têtes des vis de fixation 500.

De manière avantageuse, comme le montre la figure 7, le centre C de la partie circulaire 121 l'ouverture traversante 120 de chaque plaquette 150 est ici décalé du grand axe E du trou oblong 122 de ladite plaquette 150 d'une distance inférieure ou égale au jeu J, c'est-à-dire inférieure à la course totale de coulissement de ladite plaquette 150 dans son logement 140. Plus précisément, le centre C de chaque partie circulaire 121 est ici décalé du grand axe E du trou oblong 122 vers l'intérieur, d'une distance égale à la moitié du jeu J, soit de 1 millimètre dans cet exemple.

Du fait du décalage entre le centre de la partie circulaire 121 et le grand axe E du trou oblong 122, lorsque le support 100 est pivoté sur la boîte électrique 10, chaque plaquette 150 est forcée d'adopter une première position de montage dans son logement 140 (figure 11). La première position de montage de la plaquette 150 dans son logement 140 est ici définie comme une position intermédiaire de la plaquette, entre la position extrême externe et la position extrême interne. Les grands axes E des trous oblongs 122 des ouvertures traversantes 120 de deux plaquettes 150 en vis-à-vis, en première position de montage sur le corps 110 du support 100, sont alors distants (diamétralement) de l'entraxe D, égal à 60 millimètres dans cet exemple.

Comme le montrent bien les figures 5 et 7, le trottoir 123 délimitant le trou oblong 122 présente ici un décroché 123A, à la jonction avec la partie circulaire 121, qui facilite le guidage du corps de vis 502 depuis la partie circulaire 121 vers le trou oblong 122.

Lorsque la plaquette 150 est dans la première position de montage (figure 11), il existe un premier jeu J1 entre le bord externe 153 de ladite plaquette 150 et la portion du bord périphérique externe 113 dudit cadre 112 qui s'étend de part et d'autre du logement 140, et un deuxième jeu J2 entre le bord interne 154 de ladite plaquette 150 et le fond 140A du logement 140. Ici, la première position de montage est une position centrale de la plaquette 150 dans son logement 140, de sorte que le premier jeu J1 est égal au deuxième jeu J2, ici égal à 1 millimètre. Tant que la vis de fixation 500 n'est pas serrée dans la boîte électrique 10, l'installateur peut déplacer, ici selon la direction transverse Y1 de coulissement, dans les deux sens de coulissement, le corps 110 du support 100 par rapport aux plaquettes 150 recevant les vis de fixation 500. Tel que représenté sur la figure 11, le corps 110 du support 100 peut être déplacé vers la droite ou vers la gauche de 1 millimètre à partir de la première position de montage qui est ici centrale.

Pour fixer le support 100 sur la boîte électrique 10, chaque vis de fixation 500 est ensuite vissée au maximum dans le fût de vissage 11 correspondant de la boîte électrique 10.

Par cette opération de vissage, la plaquette 150 est serrée contre le corps 110 du support 100, lui-même alors plaqué contre la face avant de la paroi d'installation par l'effet de bride des moyens d'appui réciproques 190 du support 100. Lorsque la vis de fixation 500 est vissée dans le fût de vissage 11 de la boîte électrique 10, la zone d'appui complémentaire 192 de la plaquette 150 est appuyée contre le trottoir d'appui 191 du logement 140 (figure 9) et force la face arrière 112B du cadre 112 du corps 110 du support 100 ; 200 à venir se plaquer contre la paroi dans laquelle est encastrée la boîte électrique 10.

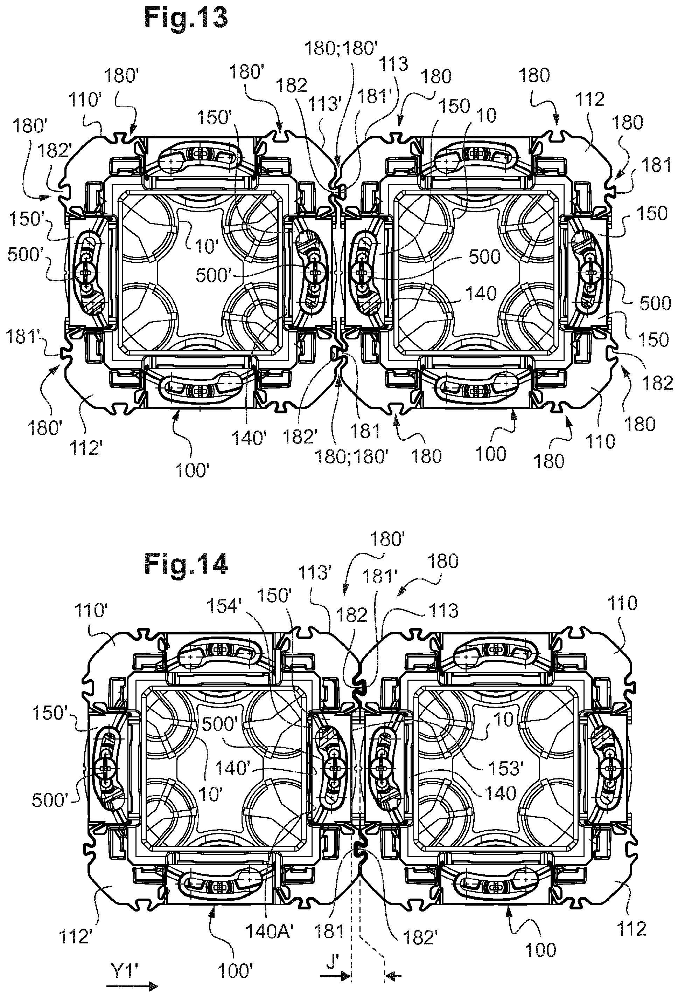

Par ailleurs, comme le montrent plus particulièrement les figures 13 et 14, le support 100 comporte sur chacune des branches de son cadre 112, des moyens de jumelage 180 à un autre support 100' du même type.

Avantageusement, les moyens de jumelage 180 permettent la solidarisation dudit support 100 (premier support 100) à un autre support 100' (deuxième support 100') du même type, de manière à former un seul support multiposte. Les dimensions hors-tout des premier et deuxième supports 100, 100' jumelés par les moyens de jumelage 180, 180' (figure 14) sont alors égales à celle d'un support multiposte formé d'un seul bloc.

Deux plaquettes 150 reçues mobiles en coulissement sur le corps 110 d'un des deux supports 100, 100', en vis-à-vis par rapport l'ouverture d'accueil 115, facilitent ce jumelage.

Comme le montre la figure 13, préférentiellement, les moyens de jumelage 180, 180' comprennent sur chaque branche du cadre 112, 112', le long du bord périphérique externe 113, 113', à l'extérieur du renfoncement, un élément mâle et un élément femelle. Lesdits moyens de jumelage 180, 180' viennent de formation avec le corps 110, 110' du support 100, 100'.

Plus particulièrement, les moyens de jumelage 180, 180' de chaque branche du cadre 112 comprennent, un ergot 181, 181' et une encoche 182, 182' de contours complémentaires, délimités par le bord périphérique externe 113, 113' du cadre 112,112'. L'ergot 181, 181' s'étend en saillie du cadre 112, 112' (élément mâle) tandis que l'encoche 182, 182' s'étend vers l'intérieur du cadre 112, 112' (élément femelle). L'ergot 181, 181' et l'encoche 182, 182' sont disposés de part et d'autre de l'entrée du logement 140,140'.

Comme le montrent les figures 13 et 14, l'ergot 181 disposé d'un côté du logement 140 du premier support 100 est destiné à s'accrocher dans l'encoche 182' prévue en correspondance sur le bord périphérique externe 113' du cadre 112' du deuxième support 100' adjacent, tandis que l'encoche 182 disposée de l'autre côté du logement 140 du premier support 100 est destinée à recevoir l'ergot 181' du deuxième support 100' adjacent.

Les moyens de jumelage 180, 180' sont identiques sur tous les côtés du cadre 112, 112', de sorte que les premier et deuxième supports 100, 100' peuvent être associés l'un à l'autre dans tous les sens, et associés à un ou plusieurs autres supports adjacents du même type. Même si on pivote le premier support 100 par rapport au deuxième support 100', les moyens de jumelage 180 du premier support 100 pivoté restent positionnés correctement par rapport aux moyens de jumelage 180' du deuxième support 100' qui n'a pas bougé, pour coopérer avec lui.

En pratique, pour jumeler les premier et deuxième supports 100, 100' entre eux, un utilisateur procède de la manière suivante : il monte et fixe le premier support 100 sur la première boîte électrique 10 de la manière décrite précédemment, puis il monte le deuxième support 100' sur la deuxième boîte électrique 10' adjacente à la première (figure 13).

Comme le montre la figure 13, après cette opération, les plaquettes 150, 150' des premier et deuxième supports 100, 100' recevant les vis de fixation 500, 500' sont toutes en première position de montage. En outre, le premier support 100 est entièrement fixe sur la première boîte électrique 10 tandis que seules les plaquettes 150' du deuxième support 100' sont fixes sur la deuxième boîte électrique 10', maintenues par les vis de fixation 500'. Un déplacement relatif des plaquettes 150' et du corps 110' du deuxième support 100', selon la direction transverse Y1' de coulissement, est encore permis puisque le deuxième support 100' est seulement monté et non fixé sur la deuxième boîte électrique 10'.

Lorsque les première et deuxième boîtes électriques 10,10' ont été encastrées dans la paroi de manière telle que les premier et deuxième supports 100, 100' ne peuvent pas être jumelés directement car ils sont trop loin l'un de l'autre (figure 13), il est encore possible d'emboîter les moyens de jumelage 180 du premier support 100 avec les moyens de jumelage 180' du deuxième support 100' en rapprochant le corps 110' du deuxième support 100' vers le corps 110 du premier support 100, selon la direction transverse Y1' de coulissement (figure 14). Après ce rapprochement permettant de rattraper le petit décalage entre les boîtes électriques 10, 10', les positions relatives de chaque plaquette 150' du deuxième support 100' qui reçoivent lesdites vis de fixation 500' et du corps 110' du deuxième support 100' ont été modifiées.

Sur la figure 14, on peut voir que les plaquettes 150' adoptent respectivement la position de repos et une deuxième position de montage dans laquelle le bord interne 154' de la plaquette 150' est au contact du fond 140A' du logement 140' correspondant. Autrement dit, une des plaquettes 150' adopte la position extrême externe (position de repos), tandis que l'autre plaquette 150' adopte la position extrême interne (deuxième position de montage). Dans la deuxième position de montage, un jeu J' existe entre le bord externe 153' de la plaquette 150' et la portion du bord périphérique externe 113' s'étendant de part et d'autre du logement 140'.

Une fois les premier et deuxième supports 100, 100' jumelés grâce au rapprochement du corps 110' du deuxième support 100' vers celui du premier support 100, les vis de fixation 500' peuvent être vissées au maximum dans la deuxième boîte électrique 10'. Les premier et deuxième supports 100, 100' ainsi jumelés peuvent alors recevoir la plaque de finition 30 biposte normalement conditionnée pour habiller un support biposte (figure 12).

Lors du démontage du support 100 de la boîte électrique 10, les deux vis de fixation 500 sont desserrées, et les lames ressorts 161 repoussent les plaquettes 150 vers l'extérieur du support 100, en direction de leur position de repos respective. La forme et le positionnement « en retrait » du trottoir 123 délimitant le trou oblong 122, aidés de la force de poussée des lames ressort 161, facilitent le pivotement angulaire inverse du support 100 visant à ramener la tête des vis 501 en face des partie circulaires 121. L'invention permet donc en outre de faciliter le démontage et l'extraction du support 100.

Le support 200 selon le deuxième mode de réalisation, représenté sur les figures 15 à 17, comporte pour élément de montage au moins un accessoire de griffage 250.

Plus précisément, le support 200 tel que représenté sur la figure 15 comporte deux éléments de montage de type plaquette 150 telle que décrite précédemment, reçus en vis-à-vis par rapport à l'ouverture d'accueil 115, et deux éléments de montage de type accessoire de griffage 250 reçus en vis-à-vis par rapport à l'ouverture d'accueil 115.

Comme le montrent plus précisément les figures 15 à 17, l'accessoire de griffage 250 comporte un socle 260, une griffe de fixation 700 logée dans ledit socle 260, une vis d'actionnement 265 engagée dans une ouverture de la griffe de fixation 700 et un écrou 267 vissée à l'extrémité du corps de la vis d'actionnement 265.

Le socle 260 est ici réalisé par moulage en matériau polymère rigide.

Il comporte une partie de montage 261 globalement plane prolongée vers l'arrière par un montant 262 logeant la griffe de fixation 700.

Comme le montrent plus précisément les figures 15 et 17, la partie de montage 261 du socle 260 de chaque accessoire de griffage 250 présente une forme globalement parallélépipédique aplatie, allongée selon une direction longitudinale L. La partie de montage 261 du socle 260 comporte plus précisément deux faces principales opposées, formant respectivement la face avant 250A et la face arrière 250B de l'accessoire de griffage 250, reliées entre elles par quatre bords latéraux constituant la tranche de ladite partie de montage 261 et formant respectivement les bords d'extrémité 250C, le bord externe 253, et le bord interne 254 dudit accessoire de griffage 250. Le bord interne 254 de l'accessoire de griffage 250 est destiné à être tourné vers l'ouverture d'accueil 115 du support 200, tandis que le bord externe 253, opposé audit bord interne 254, est destiné à être tourné vers l'extérieur du support 200.

La partie de montage 261 du socle est essentiellement pleine à l'exception, d'une part, des coulisses 292 prévues sur la face arrière et de l'encoche 272 prévue sur la face avant et destinées respectivement au coulissement et au blocage de l'accessoire de griffage 250 sur le corps 210, et, d'autre part, d'une ouverture traversante débouchant sur la face avant et sur la face arrière de la partie de montage 261 et destinée au passage de la vis d'actionnement 265.

Ainsi, comme le montre la figure 16, la partie de montage 261 du socle 260 de chaque accessoire de griffage 250 présente une forme globalement complémentaire de la forme du logement 140 du corps 110, les bords latéraux 140B opposés dudit logement 140 présentant cette fois une longueur identique à celle des bords d'extrémité 250C dudit accessoire de griffage 250. Lorsque l'accessoire de griffage 250 est assemblé sur le corps 110, ce dernier est donc immobilisé dans le logement 140.

Comme le montre la figure 17, le montant 262 du socle 260 s'étend à partir de la face arrière de la partie de montage 261, globalement perpendiculairement à ladite partie de montage 261, au droit du bord interne de cette partie montage 261. Il présente une forme globalement parallélépipédique allongée selon la direction X perpendiculaire à la face arrière de la partie de montage 261. Le montant 262 s'étend à distance des autres bords latéraux de la partie de montage 261 de sorte qu'il s'étend à distance des bords latéraux 140B du logement 140 lorsque l'accessoire de griffage 250 est assemblé sur le corps 110.

Une face externe du montant 262, orientée vers l'extérieur du support 200, délimite un premier emplacement pour le passage du corps de la vis d'actionnement qui s'étend selon la direction X dans le prolongement de l'ouverture traversante prévue sur la face avant 250A de l'accessoire de griffage 250, et un deuxième emplacement qui s'étend dans le prolongement du premier emplacement et qui forme un logement 263 pour la griffe de fixation 700. Pour le reste, le montant 262 est globalement plein.

La griffe de fixation 700 est réalisée par découpe et pliage d'un feuillard métallique brut. Elle est donc de fabrication peu onéreuse.

Comme le montre la figure 17, la griffe de fixation 700 présente globalement une configuration en U avec une paroi principale 701 et deux jambages latéraux 702.

La paroi principale 701 est rectangulaire et plane. Elle comporte dans sa partie médiane l'ouverture servant au passage de la vis d'actionnement 265. Les deux jambages latéraux 702 forment deux pattes d'accrochage parallèles qui s'étendent à partir des extrémités de la paroi principale 701. Les extrémités libres de ces deux jambages latéraux présentent chacune, sur leur tranche extérieure destinée à être tournée vers la paroi latérale 15 de la boîte électrique 10, une dent 703 pointue adaptée à s'accrocher à cette paroi latérale 15.

De manière classique, la griffe de fixation 700 est montée basculante sur le socle 260, autour d'un axe orthogonal à l'axe d'extension de la vis d'actionnement 265, ici autour d'un axe s'étendant selon la direction longitudinale L, entre une position escamotée dans laquelle elle est intégralement logée dans le montant 262 et une position déployée dans laquelle elle fait en partie saillie dudit montant 262. Ainsi, dans la position déployée, les dents 703 des jambages latéraux 702 peuvent s'accrocher à la paroi latérale 15 de la boîte électrique 10.

Telle que représentée sur la figure 17, la vis d'actionnement 265 permettant la bascule de la griffe de fixation 700 est montée libre en rotation dans le socle 260. Elle traverse de part en part l'ouverture prévue dans la partie de montage 261, le premier emplacement du montant 262, passe au travers de l'ouverture prévue dans la paroi principale 701 de la griffe de fixation 700 et traverse enfin l'écrou 267 qui est situé du côté de son extrémité libre. Seule la tête de la vis d'actionnement 265 est accessible depuis la face avant 250A de l'accessoire de griffage 250 (figure 16).

Comme le montre la figure 17, l'écrou 267 présente ici une forme sensiblement parallélépipédique. Il est positionné dans le logement 263 de la griffe de fixation, en regard d'une face arrière de la paroi principale 701 de la griffe de fixation 700, entre les deux jambages latéraux 702. Cet écrou 267 est traversé par un puits taraudé avec lequel le corps fileté de la vis d'actionnement 265 est en prise. Il est guidé en translation suivant la direction X par, d'une part, la rotation de la vis d'actionnement 265, et, d'autre part, les jambages latéraux 702 de la griffe de fixation 700 entre lesquels ledit écrou 267 s'étend, lesdits jambages latéraux 702 empêchant la rotation de l'écrou puisqu'ils s'étendent à une distance l'un de l'autre égale, au jeu près, à la largeur de l'écrou 267 (selon la direction longitudinale L).

Tels que représentés notamment sur la figure 17, les axes d'extension parallèles des jambages latéraux 702 de la griffe de fixation 700 sont inclinés par rapport au plan d'extension de la paroi principale 701 de la griffe de fixation 700.

L'écrou 267 présente quant à lui une face supérieure plane perpendiculaire à la direction X.

De cette manière, lorsque l'installateur visse la vis d'actionnement 265, la paroi principale 701 de la griffe de fixation 700 est poussée par la face supérieure de l'écrou 267 contre une surface de butée du montant 262 du socle 260 de l'accessoire de griffage 250, si bien que la griffe de fixation 700 se redresse progressivement depuis sa position escamotée jusqu'à sa position déployée dans laquelle la paroi principale 701 de la griffe de fixation 700 s'applique parfaitement contre la face supérieure de l'écrou 267.

Plus précisément, la surface de butée est ici constituée par une paroi du montant 262 délimitant, vers l'avant, le logement 263 de la griffe de fixation 700.

Lorsque la griffe de fixation 700 est enfoncée dans la paroi latérale 15 de la boîte électrique 10, la zone d'appui complémentaire 292 de l'accessoire de griffage 250 est appuyée contre le trottoir d'appui 191 du logement 140 (figure 9) et force la face arrière 112B du cadre 112 du corps 110 du support 100 ; 200 à venir se plaquer contre la paroi dans laquelle est encastrée la boîte électrique 10.

De manière avantageuse, contrairement aux supports d'appareillage électrique mixtes connus, comportant une paire d'ouvertures traversantes côte à côte, dont une est destinée au passage d'une vis de fixation à une boîte électrique et l'autre au passage éventuel d'une vis d'actionnement de la griffe de fixation d'un accessoire de griffage, le support 100 ; 200 selon l'invention peut être adapté aux conditions d'utilisation en changeant simplement les éléments de montage que son corps reçoit. L'installateur peut ainsi choisir d'assembler des plaquettes en matériaux polymère sur le corps, ou des plaquettes en matériau métallique, ou encore des accessoires de griffage, en fonction de l'utilisation à laquelle est destiné le support.

Le support selon l'invention n'est nullement limité au mode de réalisation décrit ci-dessus et de nombreuses variantes peuvent être envisagées et combinées entre elles.

Notamment, on peut aussi envisager que le cadre du corps du support présente une forme globalement circulaire. Dans ce cas, la direction transverse de coulissement de la plaquette sur le corps du support est radiale par rapport audit cadre.

Dans le cas où le bord périphérique interne du cadre délimite une ouverture d'accueil de forme circulaire, la direction transverse de coulissement est globalement perpendiculaire à une tangente du bord périphérique interne, au niveau du point de ce bord périphérique interne le plus proche du logement.

L'invention peut aussi s'appliquer à un support multiposte d'un seul bloc adapté à recevoir plusieurs mécanismes d'appareillage électrique via plusieurs ouvertures d'accueil, et à être fixé sur une boîte électrique multiposte.

## Revendications

1. Support d'appareillage électrique (100 ; 200) comportant
- un corps (110) comprenant un cadre (112) délimité par, d'une part, un bord périphérique interne (111) délimitant une ouverture d'accueil (115) destinée à accueillir un mécanisme d'appareillage électrique (20), et, d'autre part, un bord périphérique externe (113) délimitant, par renfoncement, au moins un logement (140), et
- au moins un élément de montage (150 ; 250) reçu dans ledit logement (140) pour la fixation dudit support d'appareillage électrique (100 ; 200) sur un élément de réception (10),
**caractérisé en ce que** ledit logement (140) comporte des moyens de coulissement (130) autorisant le coulissement dudit élément de montage (150 ; 250) pour son assemblage dans le logement (140), en translation selon une direction transverse (Y1, Y2) qui est globalement perpendiculaire à la partie du bord périphérique interne (111) la plus proche dudit logement (140) et qui s'étend dans un plan moyen d'extension du cadre (112),
**en ce que** ledit logement (140) comporte deux bords latéraux (140B) opposés, parallèles entre eux, et les moyens de coulissement (130) s'étendent le long de ces bords latéraux (140B) opposés, et
**en ce que** lesdits moyens de coulissement (130) sont adaptés à coopérer avec des moyens de coulissement complémentaires prévus à la périphérie dudit élément de montage (150 ; 250).

2. Support d'appareillage électrique selon la revendication 1, dans lequel les moyens de coulissement (130) forment en outre des moyens de solidarisation de l'élément de montage (150 ; 250) sur le corps (110).

3. Support d'appareillage électrique selon l'une des revendications 1 et 2, dans lequel il est en outre prévu des moyens de blocage (170 ; 270) interposés entre le corps (110) et l'élément de montage (150 ; 250) pour maintenir ledit élément de montage (150 ; 250) assemblé sur ledit corps (110) du support d'appareillage (100 ; 200).

4. Support d'appareillage électrique (100 ; 200) selon l'une des revendications 1 à 3, dans lequel le corps (110) comporte en outre un trottoir d'appui (191) adapté à s'appliquer contre une zone d'appui complémentaire (192 ; 292) dudit élément de montage (150 ; 250).

5. Support d'appareillage électrique (100 ; 200) selon l'une des revendications 1 à 4, dans lequel ledit élément de montage (150 ; 250) est réalisé au moins en partie en un matériau polymère rigide.

6. Support d'appareillage électrique (100 ; 200) selon l'une des revendications 1 à 5, dans lequel ledit élément de montage comporte une plaquette (150) munie d'une ouverture traversante (120) pour le passage d'un élément de fixation (500) destiné à fixer le support d'appareillage (100 ; 200) à l'élément de réception (10).

7. Support d'appareillage électrique (100 ; 200) selon la revendication 6, dans lequel ladite ouverture traversante (120) est de forme globalement allongée selon une direction longitudinale (L) perpendiculaire à ladite direction transverse (Y1, Y2) de coulissement de ladite plaquette (150) dans ledit logement (140).

8. Support d'appareillage électrique (100 ; 200) selon l'une des revendications 6 et 7, dans lequel la plaquette (150) est mobile dans ledit logement (140), entre une position extrême externe dans laquelle une partie (153) de la tranche de la plaquette (150), orientée vers l'extérieur du support d'appareillage (100 ; 200), s'étend globalement dans l'alignement d'une partie (113A) du bord périphérique externe (113) du cadre (112) qui s'étend de part et d'autre du logement (140), et une position extrême interne dans laquelle une autre partie (154) de la tranche de la plaquette (150), orientée vers l'intérieur du support d'appareillage (100 ; 200), est en contact avec une autre partie (113B) du bord périphérique externe (113) du cadre (112) qui forme le fond (140A) du logement (140).

9. Support d'appareillage électrique (100 ; 200) selon la revendication 8, dans lequel ladite ouverture traversante (120) de la plaquette (150) présente une forme en trou de serrure avec une partie circulaire (121) pour le passage de la tête (501) dudit élément de fixation (500) et une partie oblongue (122) prolongeant ladite partie circulaire (121), dont la largeur est inférieure au diamètre de la partie circulaire (121) et dont le grand axe (E) est décalé du centre (C) de la partie circulaire (121) d'une distance inférieure ou égale à la course totale de coulissement (J) de la plaquette (150) dans le logement (140).

10. Support d'appareillage électrique (100 ; 200) selon l'une des revendications 1 à 5, dans lequel ledit élément montage comporte un accessoire de griffage (250) muni d'une griffe de fixation (700) destinée à fixer ledit support d'appareillage (100 ; 200) sur l'élément de réception (10).

11. Support d'appareillage électrique (100 ; 200) selon l'une des revendications 1 à 10, dans lequel ledit bord périphérique externe (113) du cadre (112) délimite, par renfoncement, deux logements (140) alignés, disposés dos à dos sur ledit cadre (112) et recevant en coulissement, selon ladite direction transverse (Y1, Y2), deux éléments de montage (150 ; 250) identiques.

12. Appareillage électrique (1) comportant un support d'appareillage électrique (100 ; 200) conforme à l'une des revendications 1 à 11, et un mécanisme d'appareillage électrique (20) fixé dans l'ouverture d'accueil (115) dudit support d'appareillage électrique (100 ; 200).

## Patentansprüche

1. Halterung für elektrische Geräte (100; 200) mit
- einem Körper (110) mit einem Rahmen (112), der einerseits durch einen inneren umlaufenden Rand (111), der eine Aufnahmeöffnung (115) für die Aufnahme eines elektrischen Gerätemechanismus (20) begrenzt, und andererseits durch einen äußeren umlaufenden Rand (113), der durch Vertiefung mindestens einen Aufnahmeraum (140) begrenzt, begrenzt ist, und
- mindestens einem Montageelement (150; 250), das im Aufnahmeraum (140) für die Befestigung der Halterung für elektrische Geräte (100; 200) auf einem Aufnahmeelement (10) aufgenommen ist,
**dadurch gekennzeichnet, daß** der Aufnahmeraum (140) Mittel (130) zum Gleiten aufweist, die das translatorische Gleiten des Montageelements (150; 250) für dessen Zusammenbau im Aufnahmeraum (140) in einer Querrichtung (Y1, Y2) ermöglichen, die im Wesentlichen senkrecht zum zu dem Aufnahmeraum (140) am nächsten befindlichen Teil des inneren umlaufenden Rands (111) ist und sich in einer mittleren Erstreckungsebene des Rahmens (112) erstreckt,
daß der Aufnahmeraum (140) zwei entgegengesetzte, zueinander parallele Seitenränder (140B) aufweist und sich die Mittel (130) zum Gleiten entlang dieser entgegengesetzten Seitenränder (140B) erstrecken, und
daß die Mittel (130) zum Gleiten dazu ausgelegt sind, mit am Rand des Montageelements (150; 250) vorgesehenen komplementären Mitteln zum Gleiten zusammenzuwirken.

2. Halterung für elektrische Geräte gemäß Anspruch 1, bei der die Mittel (130) zum Gleiten außerdem Mittel zum Befestigen des Montageelements (150; 250) am Körper (110) bilden.

3. Halterung für elektrische Geräte gemäß einem der Ansprüche 1 und 2, bei der außerdem zwischen dem Körper (110) und dem Montageelement (150; 250) eingefügte Blockademittel (170; 270) vorgesehen sind, um das Montageelement (150; 250) an dem Körper (110) der Halterung für Geräte (100; 200) befestigt zu halten.

4. Halterung für elektrische Geräte (100; 200) gemäß einem der Ansprüche 1 bis 3, bei der der Körper (110) außerdem eine Andruckfläche (191) aufweist, die dazu ausgelegt ist, an einer komplementären Andruckzone (192; 292) des Montageelements (150; 250) anzuliegen.

5. Halterung für elektrische Geräte (100; 200) gemäß einem der Ansprüche 1 bis 4, bei der das Montageelement (150; 250) mindestens teilweise aus einem steifen Polymermaterial hergestellt ist.

6. Halterung für elektrische Geräte (100; 200) gemäß einem der Ansprüche 1 bis 5, bei der das Montagelement eine mit einer Durchgangsöffnung (120) zum Hindurchführen eines für die Befestigung der Gerätehalterung (100; 200) am Aufnahmeelement (10) bestimmten Befestigungselements (500) versehene Platte (150) aufweist.

7. Halterung für elektrische Geräte (100; 200) gemäß Anspruch 6, bei der die Durchgangsöffnung (120) eine im Wesentlichen längliche, sich in einer zur Quergleitrichtung (Y1, Y2) der Platte (150) im Aufnahmeraum (140) senkrechten Längsrichtung (L) erstreckende Form hat.

8. Halterung für elektrische Geräte (100; 200) gemäß einem der Ansprüche 6 und 7, bei der die Platte (150) im Aufnahmeraum (140) bewegbar ist, und zwar zwischen einer äußeren Endposition, in der sich ein Teil (153) der nach außerhalb der Gerätehalterung (100; 200) gerichteten Seitenkante (153) im Wesentlichen in Verlängerung eines Teils (113A) des äußeren umlaufenden Rands (113) des sich beiderseits des Aufnahmeraums (140) erstreckenden Rahmens (112) erstreckt, und einer inneren Endposition, in der ein anderer Teil (154) der nach innerhalb der Gerätehalterung(100; 200) gerichteten Seitenkante der Platte (150) mit einem anderen Teil (113B) des äußeren umlaufenden Rands (113) des den Boden (140A) des Aufnahmeraums (140) bildenden Rahmens (112) in Kontakt ist.

9. Halterung für elektrische Geräte (100; 200) gemäß Anspruch 8, bei der die Durchgangsöffnung (120) der Platte (150) eine Form eines Schlüssellochs mit einem kreisförmigen Teil (121) zum Hindurchführen des Kopfes (501) des Befestigungselements (500) und einem den kreisförmigen Teil (121) verlängernden länglichen Teil (122), dessen Breite geringer als der Durchmesser des kreisförmigen Teils (121) ist und dessen Hauptachse (E) gegenüber dem Mittelpunkt (C) des kreisförmigen Teils (121) um einen Abstand, der kleiner als oder gleich dem gesamten Gleitweg (J) der Platte (150) im Aufnahmeraum (140) ist, versetzt ist, aufweist.

10. Halterung für elektrische Geräte (100; 200) gemäß einem der Ansprüche 1 bis 5, bei der das Montageelement ein mit einer Befestigungskralle (700) versehenes Zusatzteil (250) zum Festhalten aufweist, das dazu bestimmt ist, die Gerätehalterung (100; 200) auf dem Aufnahmeelement (10) zu befestigen.

11. Halterung für elektrische Geräte (100; 200) gemäß einem der Ansprüche 1 bis 10, bei der der äußere umlaufende Rand (113) des Rahmens (112) durch Vertiefung zwei aufeinander ausgerichtete Aufnahmeräume (140) begrenzt, die auf dem Rahmen (112) Rücken an Rücken angeordnet sind und in der Querrichtung (Y1, Y2) gleitend zwei identische Montageelemente (150; 250) aufnehmen.

12. Elektrisches Gerät (1) mit einer Halterung für elektrische Geräte (100; 200) gemäß einem der Ansprüche 1 bis 11 und einem in der Aufnahmeöffnung (115) der Halterung für elektrische Geräte (100; 200) befestigten elektrischen Gerätemechanismus (20).

## Claims

1. Electrical equipment support (100; 200) comprising:
- a body (110) comprising a frame (112) delimited by, on the one hand, an inner peripheral edge (111) delimiting an accommodating opening (115) intended to accommodate an electrical equipment mechanism (20), and, on the other hand, an outer peripheral edge (113) delimiting, by recessing, at least one housing (140), and
- at least one mounting element (150; 250) received in said housing (140) for fixing said electrical equipment support (100; 200) to a receiving element (10),
**characterised in that** said housing (140) comprises sliding means (130) allowing the sliding of said mounting element (150; 250) for its assembly in the housing (140), in translation along a transverse direction (Y1, Y2) which is globally perpendicular to the portion of the inner peripheral edge (111) closest to said housing (140) and which extends in a mean extension plane of the frame (112),
**in that** said housing (140) comprises two opposite side edges (140B), parallel to each other, and the sliding means (130) extend along these opposite side edges (140B), and
**in that** said sliding means (130) are designed to cooperate with complementary sliding means provided at the periphery of said mounting element (150; 250).

2. Electrical equipment support according to claim 1, wherein the sliding means (130) further form means for securing the mounting element (150; 250) to the body (110).

3. Electrical equipment support according to any one of claims 1 and 2, wherein locking means (170; 270) are also provided, interposed between the body (110) and the mounting element (150; 250), for holding said mounting element (150; 250) assembled on said body (110) of the equipment support (100; 200).

4. Electrical equipment support (100; 200) according to any one of claims 1 to 3, wherein the body (110) further comprises a bearing ledge (191) adapted to apply against a complementary bearing area (192; 292) of said mounting element (150; 250).

5. Electrical equipment support (100; 200) according to any one of claims 1 to 4, wherein said mounting element (150; 250) is made at least in part of a rigid polymer material.

6. Electrical equipment support (100; 200) according to any one of claims 1 to 5, wherein said mounting element comprises a plate (150) provided with a through opening (120) for the passage of a fixing element (500) intended to fix the equipment support (100; 200) to the receiving element (10).

7. Electrical equipment support (100; 200) according to claim 6, wherein said through opening (120) is generally elongated in a longitudinal direction (L) perpendicular to said transverse direction (Y1, Y2) of sliding of said plate (150) in said housing (140).

8. Electrical equipment support (100; 200) according to any one of claims 6 and 7, wherein the plate (150) is movable in said housing (140) between an extreme outer position in which a portion (153) of the rim of the plate (150), facing outwards from the equipment support (100; 200), extends generally in alignment with a portion (113A) of the outer peripheral edge (113) of the frame (112) that extends on either side of the housing (140), and an extreme inner position in which another portion (154) of the rim of the plate (150), facing inwards from the equipment support (100; 200), is in contact with another portion (113B) of the outer peripheral edge (113) of the frame (112) that forms the bottom (140A) of the housing (140).

9. Electrical equipment support (100; 200) according to claim 8, wherein said through opening (120) of the plate (150) has a keyhole shape with a circular portion (121) for the passage of the head (501) of said fixing element (500) and an oblong portion (122) extending said circular portion (121), the width of which is less than the diameter of the circular portion (121) and the major axis (E) of which is offset from the centre (C) of the circular portion (121) by a distance less than or equal to the total sliding stroke (1) of the plate (150) in the housing (140).

10. Electrical equipment support (100; 200) according to any one of claims 1 to 5, wherein said mounting element comprises a catch assembly (250) provided with a fixing claw (700) for fixing said equipment support (100; 200) to the receiving element (10).

11. Electrical equipment support (100; 200) according to one of claims 1 to 10, wherein said outer peripheral edge (113) of the frame (112) delimits, by recessing, two aligned housings (140), arranged back to back on said frame (112) and slidably receiving, along said transverse direction (Y1, Y2), two identical mounting elements (150; 250).

12. Electrical equipment (1) comprising an electrical equipment support (100; 200) according to any one of claims 1 to 11, and an electrical equipment mechanism (20) fixed in the accommodating opening (115) of said electrical equipment support (100; 200).
